# EUROPEAN PATENT SPECIFICATION

(11) **EP 4 064 538 B1**
(45) Date of publication and mention of the grant of the patent: **10.09.2025**
(21) Application number: 20889604.3
(22) Date of filing: 25.05.2020
(51) Int. Cl.: H02M 1/08, H03K 17/0812, H03K 17/16, H03K 17/605, H03K 17/61, H03K 17/689, H03K 17/691, H03K 17/78

(54) **DRIVER CIRCUIT OF POWER CONVERSION DEVICE AND APPLICATION DEVICE THEREOF**
TREIBERSCHALTUNG EINER LEISTUNGSWANDLUNGSVORRICHTUNG UND ANWENDUNGSVORRICHTUNG DAFÜR
CIRCUIT D'ATTAQUE DE DISPOSITIF DE CONVERSION DE COURANT ET SON DISPOSITIF D'APPLICATION

(30) Priority: 18.11.2019 CN 201911127613
(43) Date of publication of application: 28.09.2022
(73) Proprietor: Sungrow Power Supply Co., Ltd., Hefei, Anhui 230088 (CN)
(72) Inventor: CHEN, Peng, Hefei, Anhui 230088 (CN); ZHU, Yin, Hefei, Anhui 230088 (CN); XU, Qingqing, Hefei, Anhui 230088 (CN)
(74) Representative: Epping - Hermann - Fischer
(86) International application number: PCT/CN2020/092060
(87) International publication number: WO 2021/098173

(56) References cited:
- CN-A- 107 027 205
- CN-A- 107 027 205
- CN-A- 110 365 197
- CN-A- 110 729 880
- CN-U- 204 465 496
- CN-U- 204 465 496
- CN-U- 208 015 701
- CN-U- 209 001 922
- JP-A- 2014 045 562
- US-A- 5 506 539
- US-A- 5 926 012
- US-A- 5 986 484
- US-A1- 2011 096 451
- US-A1- 2018 337 673

## Description

The present application claims priority to Chinese Patent Application No. 201911127613.0, titled "DRIVER CIRCUIT OF POWER CONVERSION DEVICE AND APPLICATION DEVICE THEREOF", filed on November 18, 2019, with the China National Intellectual Property Administration.

### FIELD

The present disclosure relates to the technical field of power electronics, and in particular, to a drive circuit of a power conversion device, and an application device thereof.

### BACKGROUND

A Metal-Oxide-Semiconductor Field-Effect Transistor (MOSFET) and an Insulated Gate Bipolar Transistor (IGBT) are widely used in power supplies of power electronic devices. The MOSFET and IGBT are both power semiconductor devices that can be turned on and off by controlling a voltage value of a drive signal. Under normal conditions, the MOSFET and IGBT can be turned on by applying a positive voltage greater than their turn-on voltages, and turned off by applying a negative voltage or a zero voltage. When turned on, the MOSFET and IGBT have a lower power loss and a better performance under a drive signal with a higher voltage value. When turned off, the voltage value of the drive signal is negative, to ensure that the MOSFET and IGBT are turned off reliably.

In practical applications, due to parasitic inductances of a switching circuit, voltage spikes appear when the MOSFET and IGBT are turned off, resulting in a high turn-off voltage stress. Moreover, reverse recovery current of a freewheel diode flows through the MOSFET and IGBT when they are turned on, thereby increasing a conduction power loss and a current stress. The voltage stress during turn-off and the current stress during turn-on both will increase a damage risk of the MOSFET and IGBT and reduce their reliability.

To avoid the above problems of the increased damage risk and the reduced reliability of the MOSFET and IGBT, one solution in the conventional technology is to adjust turn-on and turn-off speeds of the MOSFET and IGBT by changing drive resistances, to reduce the corresponding stress. However, the performance of the MOSFET and IGBT during normal operation and abnormal operation cannot both be satisfied if the drive resistances are adjusted permanently.

US5926012A1 discloses a gate drive circuit in a power converter that includes a voltage-driven switching device, and a gate drive circuit connected to the voltage-driven switching device for driving the same. The gate drive circuit includes a detection device for detecting a physical quantity in the switching device, and an operation device for changing a gate drive condition of the switching device. When an output of the detection means becomes a value outside a specified value at a turn-on or turn-off operation of the switching device, the operation device changes the gate drive condition instantaneously or for a predetermined time to reduce a voltage applied to the switching device.

CN107027205A discloses an electromagnetic heating apparatus and a driving circuit of a power switch tube used in the electromagnetic heating apparatus. The driving circuit comprises an integrated driving chip and a control chip, wherein the integrated driving chip has a driving output port, a chip power supply port, a driving voltage control signal input port and a main control signal input port; the integrated driving chip outputs a driving signal to the power switch tube to drive the switch-on and switch-off of the power switch tube through the driving output port; the integrated driving chip is integrated with a voltage conversion unit for changing the driving voltage corresponding to the driving signal; and the control chip controls the integrated driving chip to enable the power switch tube to be operated in an amplified state when the power switch tube is started, and controls the integrated driving chip to enable the power switch tube to be operated in a saturated switch-on state after the starting of the power switch tube is completed. By integrating the integrated driving chip with the voltage conversion unit on the driving circuit, the pulse current in the switch-on moment of the power switch tube can be lowered, and damage of the power switch tube can be avoided.

JP 2014045562A discloses an inverter device capable of preventing a reflux diode etc. from being damaged. The inverter device includes: a pair of upper and lower switching elements 1 connected to a DC voltage source 4 to supply the power to an inductive load 5; a reflux diode 2 which is connected to the switching element in inverse-parallel thereto; and a control section 3 that controls the switching element. The control section is configured to input a signal smaller than a control signal to the switching element to activate the inductive load immediately before the control signal which is input to the switching element. With this simple configuration, since short-circuit current can be reduced when the reflux diode is activated at inverse recovery, the efficiency is increased by reducing the power loss, and further the switching element and the diode can be prevented from being damaged.

### SUMMARY

An object of the present disclosure is to provide a drive circuit of a power conversion device and an application device thereof, to switch a drive voltage between a preset voltage and a normal voltage without permanently adjusting resistance of a drive resistor, thereby avoiding affecting performance of the power conversion device during normal operation.

In one aspect, a drive circuit of a power conversion device is provided according to the present disclosure, as defined in independent claim 1.

Further preferred embodiments are defined in the dependent claims.

### BRIEF DESCRIPTION OF THE DRAWINGS

Figure 1 is a schematic diagram of a drive circuit of a power conversion device according to an embodiment of the present disclosure;
Figure 2 is a schematic diagram of a power switching circuit in a drive circuit of a power conversion device according to an embodiment of the present disclosure;
Figure 3 is a schematic diagram of a power switching circuit in a drive circuit of a power conversion device according to an embodiment of the present disclosure;
Figure 4 is a schematic diagram of a power switching circuit in a drive circuit of a power conversion device according to an embodiment of the present disclosure;
Figure 5 is a schematic diagram of an inverter according to an embodiment of the present disclosure;
Figure 6 is a schematic diagram of a power switching circuit in a drive circuit of a power conversion device according to an embodiment of the present disclosure;
Figure 7 is a schematic diagram of a drive circuit of a power conversion device according to an embodiment of the present disclosure; and
Figure 8 is a schematic diagram of a power conversion device according to an embodiment of the present disclosure.

### DETAILED DESCRIPTION

To make the objectives, technical solutions, and advantages of the embodiments of the present disclosure clearer, the technical solutions in the embodiments of the present disclosure will be described clearly and completely hereinafter in conjunction with the drawings in the embodiments of the present disclosure. Apparently, the described embodiments are only a part of the embodiments of the present disclosure, rather than all embodiments. Based on the embodiments in the present disclosure, all of other embodiments, made by the person skilled in the art without any creative efforts, fall into the scope of protection of the present disclosure.

The term "include", "comprise" or any variant thereof is intended to encompass nonexclusive inclusion so that a process, method, article or device including a series of elements includes not only those elements but also other elements which have not been listed definitely or an element(s) inherent to the process, method, article or device. Moreover, the expression "comprising a(n) ......" in which an element is defined will not preclude presence of an additional identical element(s) in a process, method, article or device comprising the defined element(s) unless further defined.

A drive circuit of a power conversion device is provided according to an embodiment of the present disclosure, to switch a drive voltage between a preset voltage and a normal voltage without permanently adjusting a resistance value of a drive resistor, avoiding affecting performance of the power conversion device during normal operation.

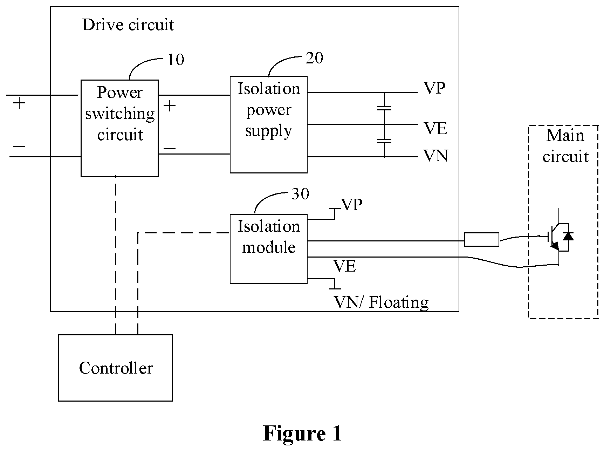

As shown in Figure 1, the drive circuit of a power conversion device includes: at least one power switching circuit 10, N isolation modules (an isolation optocoupler 30 is taken as an example hereinafter), and at least one isolation power supply 20, N being a positive integer representing a number of power semiconductor devices in a main circuit of the power conversion device. A control terminal of each of the N power semiconductor devices is connected, through a respective drive resistor, to an output terminal of a corresponding isolation module 30. A power supply terminal of each of the N isolation modules 30 is connected to an output terminal of a corresponding isolation power supply 20, and is configured to receive a corresponding drive voltage. It should be noted that the output terminal of the isolation power supply 20 includes: a positive voltage output terminal, a control voltage output terminal, and a negative voltage output terminal, and a capacitor is arranged between each two adjacent output terminals of the three output terminals. An output voltage of the positive voltage output terminal is VP, an output voltage of the control voltage output terminal is VE, and an output voltage of the negative voltage output terminal is VN. The power supply terminal of the isolation module 30 includes: a positive voltage input terminal, a control voltage input terminal, and a negative voltage input terminal. The specific connection relationship between the isolation module 30 and the isolation power supply 20 is: the positive voltage input terminal of the isolation module 30 is connected to the positive voltage output terminal of the isolation power supply 20, the control voltage input terminal of each isolation module 30 is connected to the control voltage output of the isolation power supply 20, and the negative voltage input terminal of the isolation module 30 is connected to the negative voltage output terminal of the isolation power supply 20. **In** this case, a voltage difference between the output voltage VP of the positive voltage output terminal and the output voltage VN of the negative voltage output terminal of the isolation power supply 20 is a drive voltage provided by the isolation power supply 20 to the isolation module 30. Alternatively, the negative voltage input terminal of the isolation module 30 may not be connected to the negative voltage output terminal of the isolation power supply 20, but is in a floating state; in this case, the output voltage VP of the positive voltage output terminal of the isolation power supply 20 is the drive voltage provided by the isolation power supply 20 to the isolation module 30.

**In** practical applications, the isolation module 30 may be any one of an isolation optocoupler, an isolation capacitive coupler, and an isolation magnetic coupler. **In** practice, the isolation module 30 may also be any other device or circuit with isolation and signal transmission functions, which will not be listed one by one herein and shall all fall within the protection scope of this disclosure.

An input terminal of the isolation power supply 20 is connected to an output terminal of the power switching circuit 10, and an input terminal of the power switching circuit 10 is connected to a power supply.

In practical applications, open-loop control is applied to the isolation power supply 20. Therefore, an output voltage of the isolation power supply 20 changes linearly with an input voltage of the isolation power supply 20. For example, if the input voltage of the isolation power supply 20 is relatively large, the output voltage thereof is large as well; while if the input voltage of the isolation power supply 20 is relatively small, the output voltage thereof is small as well. Thus, a voltage outputted to the isolation power supply 20 by the power switching circuit 10 changes linearly with the drive voltage outputted by the isolation power supply 20.

In practical applications, multiple power semiconductor devices inside an power conversion module in a power conversion device, such as an inverter circuit or a DC/DC conversion circuit, are each equipped with a respective isolation module 30. Multiple isolation modules 30, for example, isolation modules for power semiconductor devices in one power conversion module, may share one isolation power supply 20, or all isolation modules 30 on a driver board of the power conversion device may share one isolation power supply 20, which will not be limited herein. In a case that multiple isolation power supplies 20 are provided on the driver board of the power conversion device, the multiple isolation power supplies 20 may share one power switching circuit 10.

When the power conversion device is in a normal operating state, the power switching circuit 10 inside the drive circuit converts a voltage received at the input terminal thereof, and outputs a converted voltage to the isolation power supply 20 through an output terminal thereof. The isolation power supply 20 outputs, through the output terminal thereof, a corresponding drive voltage to a power supply terminal of the isolation module 30. An input terminal of each isolation module 30 is connected to a first output terminal of a controller in the power conversion device, and receives a PWM signal for a corresponding power semiconductor device. Each isolation module 30 outputs, through an output terminal thereof, a drive signal to a control terminal of a respective power semiconductor device according to the PWM signal, so that each power semiconductor device performs a corresponding action according to the drive signal.

A control terminal of the power switching circuit 10 is connected to a second output terminal of the controller, and receives a drive voltage control signal. The power switching circuit 10 changes an output thereof according to the drive voltage control signal received by the control terminal thereof, such that a drive voltage of each isolation module 30 is equal to a preset voltage when the power conversion device is in a transient process, and is equal to a normal voltage when the power conversion device is in a normal operating state.

Specifically, the transient process refers to a process such as a low voltage ride through process, a high voltage ride through process, a startup process, and a shutdown process. When the power conversion device is in any of the above transient processes, the controller of the power conversion device outputs a first drive voltage control signal, for example, a drive voltage control signal at a certain level, to the control terminal of the power switching circuit 10, to make sure that an output voltage of the power switching circuit 10 is low, and thereby the drive voltage of each isolation module 30 is equal to the preset voltage. When the power conversion device is in the normal operating state, the controller of the power conversion device outputs a second drive voltage control signal, for example, a drive voltage control signal at another level, to the control terminal of the power switch circuit 10, to make sure that an output voltage of the power switching circuit 10 is high, and thereby the drive voltage of each isolation module 30 is equal to the normal voltage. The preset voltage is lower than the normal voltage, so as to ensure that in any one of the transient processes, such as the low voltage ride through process, the high voltage ride through process, the startup process and the shutdown process, drive signals received by the power semiconductor devices in the main circuit change relative to those in the normal operation of the power conversion device and slow down the turning on and turning off of the power semiconductor devices, so that a voltage stress during turn-off and a current stress during turn-on are within a permitted range, thereby reducing a damage risk of the power semiconductor devices and improving the reliability thereof. Moreover, the resistance of a drive resistor does not require to be adjusted permanently, which avoids impact on the performance of the power conversion device during normal operation. It should be noted that, in practical applications, the preset voltage may be higher than the normal voltage, as long as it can ensure that when the power conversion device is in any of the transient processes such as the low voltage ride through process, the high voltage ride through process, the startup process, and the shutdown process, turn-on and turn-off speeds of each power semiconductor device are lowered, so that the voltage stress during turn-off and the current stress during turn-on are both within the permitted range, which shall all fall within the protection scope of the present disclosure.

In the conventional technology, there is another solution that a drive resistor or a voltage regulating circuit is arranged on a secondary side of an isolation power supply. However, in either case, it requires two isolation channels to respectively control different drive resistor cut-in circuits or realize different functions, resulting in higher circuit cost and higher complexity.

In embodiments of the present disclosure, by changing a voltage on a primary side of the isolation power supply 20, a voltage on a secondary side of the isolation power supply 20 is changed accordingly, thus the requirement for multiple isolation channels in the conventional technology is avoided. Moreover, one power switching circuit 10 may correspond to multiple isolation power supplies 20 without changing the isolation power supply 20 and the isolation module 30, thereby further reducing the circuit cost and the complexity of the circuit.

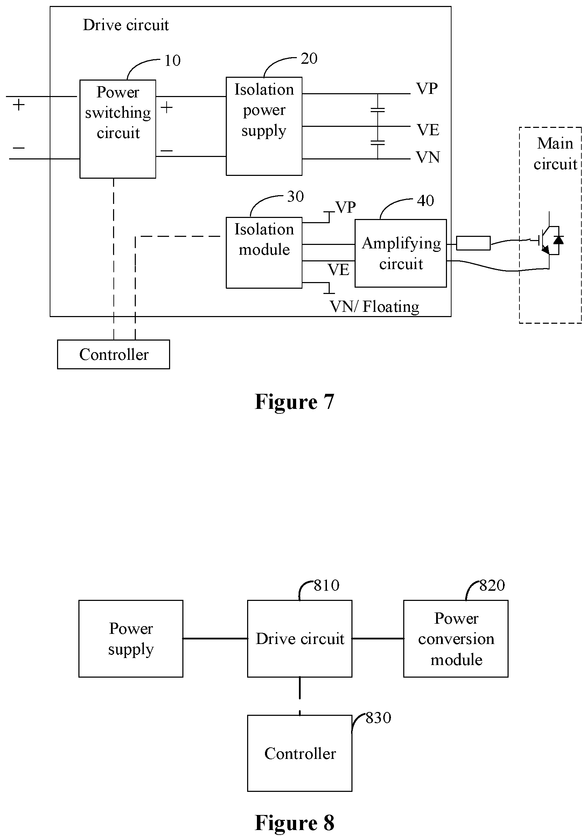

On the basis of the embodiment of Figure 1, the drive circuit of a power conversion device may further include an amplifying circuit 40 as shown in Figure 7. The control terminal of each of the N power semiconductor devices is connected, through the respective drive resistor thereof, to an output terminal of a corresponding amplifying circuit 40; and an input terminal of each amplifying circuit is connected to the output terminal of a corresponding isolation module 30.

It should be noted that the connection relationship of other components in Figure 7 is similar to the connection relationship in Figure 1, and reference may be made to the embodiment of Figure 1, which will not be described again herein, and shall all fall within the protection scope of the present disclosure.

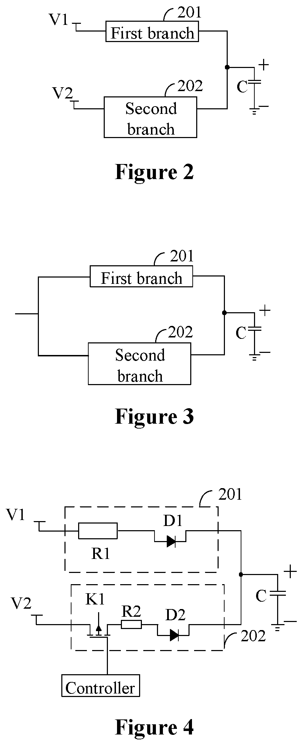

In practical applications, a specific structure of the power switching circuit 10 is shown in Figure 2, including: a capacitor C, and a first branch 201 and a second branch 202 with different output voltages. At least one of the first branch 201 and the second branch 202 is provided with a control terminal functioning as the control terminal of the power switching circuit 10. An input terminal of the first branch 201 functions as an input terminal of the power switching circuit 10, and is connected to a first power supply V1. An input terminal of the second branch 202 functions as another input terminal of the power switching circuit 10, and is connected to a second power supply V2. An output terminal of the first branch 201 and an output terminal of the second branch 202 are both connected to an terminal of the capacitor C, and a connection point thereof functions as a positive electrode of the output terminal of the power switching circuit 10; and another terminal of the capacitor C is grounded, and functions as a negative electrode of the output terminal of the power switching circuit 10.

In practical applications, the first branch 201 as shown in Figure 4 includes a first current-limiting resistor R1 and a first diode D1. A cathode of the first diode D1 functions as the output terminal of the first branch 201, an anode of the first diode D1 is connected to an terminal of the first current-limiting resistor R1, and another terminal of the first current-limiting resistor R1 functions as the input terminal of the first branch 201.

The second branch as shown in Figure 4 includes: a second current-limiting resistor R2, a first electronic switch K1, and a second diode D2 that are connected in series. A cathode of the second diode D2 functions as the output terminal of the second branch 202, and an anode of the second diode D2 is connected to an output terminal of the first electronic switch K1 through the second current-limiting resistor R2; and an input terminal of the first electronic switch K1 functions as the input terminal of the second branch 202, and a control terminal of the first electronic switch K1 functions as the control terminal of the power switching circuit 10.

The first electronic switch K1 is any one of a MOSFET, a triode, an IGBT, or a combination of at least two of a MOSFET, a triode, and an IGBT. The first electronic switch K1 may also be other semiconductor switches, depending on actual situations, which will not be listed herein, and shall all fall within the protection scope of the present disclosure.

In practical applications, an output voltage of the first branch 201 is less than an output voltage of the second branch 202.

The first power supply V1, the second power supply V2, the first current-limiting resistor R1, and the second current-limiting resistor R2 may be configured as follows: a voltage of the second power supply V2 is greater than a voltage of the first power supply V1, and a resistance value of the first current-limiting resistor R1 is equal to a resistance value of the second current-limiting resistor R2.

Alternatively, the first power supply V1, the second power supply V2, the first current-limiting resistor R1, and the second current-limiting resistor R2 may be configured as follows: the voltage of the second power supply V2 is equal to the voltage of the first power supply V1, and the resistance value of the first current-limiting resistor R1 is greater than the resistance value of the second current-limiting resistor R2. In this case, the first power supply V1 and the second power supply V2 may be the same power supply, and the input terminal of the first branch 201 is connected to the input terminal of the second branch 202, which is shown in Figure 3, and other connection relationships of the first branch and the second branch are similar to those in Figure 4, which will not be described again herein.

Alternatively, the first power supply V1, the second power supply V2, the first current-limiting resistor R1, and the second current-limiting resistor R2 may be configured as follows: the voltage of the second power supply V2 is greater than the voltage of the first power supply V1, and the resistance value of the first current-limiting resistor R1 is greater than the resistance value of the second current-limiting resistor R2.

The aforementioned three cases are all to ensure that the output voltage of the first branch 201 is smaller than the output voltage of the second branch 202, and other ways to ensure that the output voltage of the first branch 201 is smaller than the output voltage of the second branch 202 shall also fall within the protection scope of the present disclosure.

In this embodiment, the drive voltage control signal is a signal that controls the first electronic switch K1 to turn on when the power conversion device is in the normal operating state, and controls the first electronic switch K1 to turn off when the power conversion device is in the transient process such as a low voltage ride through process, a high voltage ride through process, a startup process, a shutdown, etc.

When the first electronic switch K1 is turned on, since the output voltage of the first branch 201 is smaller than the output voltage of the second branch 202, the first diode D1 in the first branch 201 will be reversely cut off, and no current flows through the first current-limiting resistor R1 in the first branch 201. In this case, only the second branch 202 outputs a voltage to the capacitor C, and thus the drive voltage is equal to the normal voltage.

When the first electronic switch K1 is turned off, that is, when the second branch 202 is disconnected, the first branch 201 outputs a voltage to the capacitor C, and the second diode D2 in the second branch 202 is reversely cut off. Since the output voltage of the first branch 201 is smaller than the output voltage of the second branch 202, the drive voltage is changed from the normal voltage to a lower preset voltage.

No matter the first branch 201 or the second branch 202 outputs a voltage to the capacitor C, a positive electrode voltage of the charged capacitor C is an output voltage of the power switching circuit 10. Since the output voltage of the first branch 201 is smaller than that of the second branch 202, when the power conversion device is in the normal operating state, the second branch 202 with a higher output voltage is controlled, according to the drive voltage control signal, to output a voltage to the capacitor C; thus, the positive electrode voltage of the charged capacitor C is higher, and the drive voltage is equal to the normal voltage. When the power conversion device is in the transient process such as a low voltage ride through process, a high voltage ride through process, a startup process and a shutdown process, the first branch 201 with a lower output voltage is controlled, according to the drive voltage control signal, to output a voltage to the capacitor C; thus, the positive electrode voltage of the charged capacitor C is reduced, and the drive voltage is equal to the preset voltage.

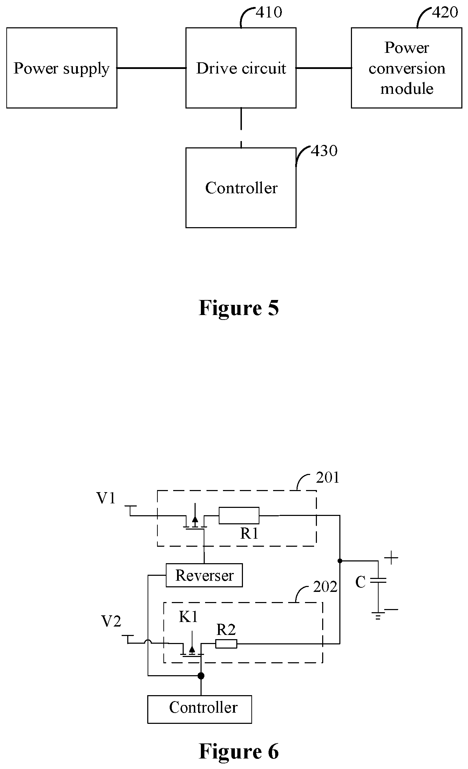

In practical applications, as shown in Figure 6, a second electronic switch K2 may be provided in the first branch 201, and a control signal of the second electronic switch K2 is reversed by an inverting buffer, so as to be opposite to a control signal of the first electronic switch K1 in the second branch 202. In this case, the diodes in the two branches can be omitted, and the working principle thereof is similar to that in the aforementioned embodiments, which will not be described again herein.

A power conversion device is provided according to an embodiment of the present disclosure. Referring to Figure 8, the power conversion device includes: a controller 830, M power conversion modules 820, and the drive circuit 810 according to any of the above embodiments.

M is a positive integer, for example, M is equal to 1 in Figure 8.

The M power conversion modules 820 include at least one of a DC/AC conversion circuit, a DC/DC conversion circuit, an AC/AC conversion circuit, and an AC/DC conversion circuit, depending on specific application environment, which is not limited herein, and shall all fall within the protection scope of the present disclosure.

The controller 830 is connected to a control terminal of each power semiconductor device in the M power conversion modules 820 through the drive circuit 810, and is configured to: output a PWM signal for a corresponding power semiconductor device to the isolation module 30 in the drive circuit 810, and thereby control each power semiconductor device in the power conversion module 820 to turn on and off. Each power semiconductor device in the power conversion module 820 may be a MOSFET, an IGBT, or any other power semiconductor device, which will not be described herein, and shall all fall within the protection scope of the present disclosure.

For details of the specific structure and working principle of the drive circuit 810, reference may be made to the aforementioned embodiments, which will not be described again herein.

An inverter is provided according to an embodiment of the present disclosure. Referring to Figure 5, the inverter includes: a controller 430, M power conversion modules 420, and the drive circuit 410 according to any of the above embodiments.

M is a positive integer, for example, M is equal to 1 in Figure 5.

The M power conversion modules include at least one inverter. That is, when M=1, the power conversion module 420 is an inverter circuit; and when M>1, the other power conversion modules 420 may be DC/DC conversion circuits.

The controller 430 is connected to a control terminal of each power semiconductor device in the M power conversion modules 420 through the drive circuit 410, and is configured to: output a PWM signal for a corresponding power semiconductor device to the isolation module 30 in the drive circuit 410, and thereby control each power semiconductor device in the power conversion module 420 to turn on and off. Each power semiconductor device in the power conversion module 420 may be a MOSFET, an IGBT, or any other power semiconductor device, which will not be described herein, and shall all fall within the protection scope of the present disclosure.

For details of the specific structure and working principle of the drive circuit 410, reference may be made to the aforementioned embodiments, which will not be described again herein.

The specific working process of the inverter is described in the following.

When the inverter is in an operating state, the controller 430 thereof outputs the PWM signal for the corresponding power semiconductor device to each isolation module 30 in the drive circuit 410, to control the corresponding power semiconductor device to turn on and off. The operating state includes: a normal operating state, and transient processes such as a low voltage ride through process, a high voltage ride through process, a startup process and a shutdown process.

Specifically, in a case that the PWM signal received by the isolation module 30 of the drive circuit 410 indicates turning off, the isolation module 30 outputs a disabling control signal to the corresponding power semiconductor device to turn off the corresponding power semiconductor device. In a case that the PWM signal received by the isolation module 30 of the drive circuit 410 indicates turning on, the isolation module 30 outputs an enabling control signal to the corresponding power semiconductor device to turn on the corresponding power semiconductor device.

When the inverter is in a normal operating state, the controller 430 controls a drive voltage of the drive circuit 410 to be equal to a normal voltage, such that each power semiconductor device in the M power conversion modules 420 outputs a normal drive signal according to the PWM signal and the inverter operates normally.

When the inverter is in a transient process such as a low voltage ride through process, a high voltage ride through process, a startup process and a shutdown process, the controller 430 controls the drive voltage of the drive circuit 410 to be equal to the preset voltage, such that turning on and turning off speeds of each power semiconductor device in the transient process such as a low voltage ride through process, a high voltage ride through process, a startup process and a shutdown process is lowered. In this way, voltage and current stresses of each power semiconductor device are reduced, thereby avoiding the damage risk of each power semiconductor device and improving the reliability thereof.

In this embodiment, the drive voltage of the drive circuit 410 is switched between the normal voltage and the preset voltage when the inverter is in different states, thereby avoiding the damage risk of power semiconductor devices in the power conversion module 420 when the inverter is in high transient voltage stress and current stress.

The embodiments in this specification are described in a progressive manner. For the same or similar parts between the embodiments, one may refer to the description of other embodiments. Each embodiment lays emphasis on differences from other embodiments. Since the system embodiment is similar to the method embodiment, the description for the system embodiment is relatively simple. For related parts, reference may be made to description in the method embodiment. The system embodiment described above are merely illustrative, and units described as separate components may or may not be physically separated. The components shown as units may be or not be physical units, i.e., the units may be located at the same place or may be distributed onto multiple network units. All or a part of the modules may be selected based on actual needs to realize the objective of the solutions according to the embodiments. The solutions according to the embodiments can be understood and implemented by those skilled in the art without creative work.

The person skilled in the art can further appreciate that the elements and algorithm steps of each embodiment described in connection with the embodiments disclosed herein can be implemented in electronic hardware, computer software or a combination of both, in order to clearly illustrate the interchangeability of the hardware and software, the composition and steps of the various examples have been generally described in terms of function in the above description. Whether these functions are performed in hardware or software depends on the specific application and design constraints of the technical solution. The person skilled in the art can use different methods for implementing the described functions for each particular application; such implementation should not be considered to be beyond the scope of the present disclosure.

Based on the above description of the disclosed embodiments, those skilled in the art are capable of carrying out or using the present disclosure.

## Claims

1. A drive circuit of a power conversion device, the drive circuit comprising: a plurality of isolation modules (30), and at least one isolation power supply (20), and a main circuit of the power conversion device comprising a plurality of power semiconductor devices, wherein:
a control terminal of each of the power semiconductor devices is connected, through a respective drive resistor, to an output terminal of a corresponding isolation module (30);
a power supply terminal of each of the isolation modules (30) is connected to an output terminal of the isolation power supply (20), and is configured to receive a corresponding drive voltage;
an input terminal of each of the isolation modules (30) is connected to a first output terminal of a controller in the power conversion device, and is configured to receive a Pulse Width Modulation, PWM, signal for a corresponding power semiconductor device; wherein the drive circuit further comprises at least one power switching circuit (10), and wherein
an input terminal of the isolation power supply (20) is connected to an output terminal of the power switching circuit (10);
an input terminal of the power switching circuit (10) is connected to a power supply;
a control terminal of the power switching circuit (10) is connected to a second output terminal of the controller, and is configured to receive a drive voltage control signal; and
the power switching circuit (10) is configured to: change an output voltage of the power switching circuit (10) according to the drive voltage control signal, whereby a drive voltage of each of the isolation modules (30) is equal to a preset voltage when the power conversion device is in a transient process, and is equal to a normal voltage when the power conversion device is in a normal operating state.

2. The drive circuit of a power conversion device according to claim 1, wherein the power switching circuit (10) comprises: a capacitor (C), a first branch (201) and a second branch (202), the first branch (201) and the second branch (202) having different output voltages, wherein:
at least one of the first branch (201) and the second branch (202) is provided with a control terminal functioning as the control terminal of the power switching circuit (10);
an input terminal of the first branch (201) functions as an input terminal of the power switching circuit (10), and is connected to a first power supply (V1);
an input terminal of the second branch (202) functions as another input terminal of the power switching circuit (10), and is connected to a second power supply (V2);
an output terminal of the first branch (201) and an output terminal of the second branch (202) are both connected to a terminal of the capacitor (C), and a connection point thereof functions as a positive electrode of the output terminal of the power switching circuit (10); and
another terminal of the capacitor (C) is grounded, and functions as a negative electrode of the output terminal of the power switching circuit (10).

3. The drive circuit of a power conversion device according to claim 2, wherein the first branch (201) comprises a first current-limiting resistor (R1) and a first diode (D1), and the second branch (202) comprises: a second current-limiting resistor (R2), a first electronic switch (K1), and a second diode (D2) that are connected in series, wherein:
a cathode of the first diode (D1) functions as the output terminal of the first branch (201), an anode of the first diode (D1) is connected to a terminal of the first current-limiting resistor (R1), and another terminal of the first current-limiting resistor (R1) functions as the input terminal of the first branch (201);
a cathode of the second diode (D2) functions as the output terminal of the second branch (202), and an anode of the second diode (D2) is connected to an output terminal of the first electronic switch (K1) through the second current-limiting resistor (R2); and
an input terminal of the first electronic switch (K1) functions as the input terminal of the second branch (202), and a control terminal of the first electronic switch (K1) functions as the control terminal of the power switching circuit (10).

4. The drive circuit of a power conversion device according to claim 2, wherein the first branch (201) comprises a first current-limiting resistor (R1) and a second electronic switch (K2) that are connected in series, and the second branch (202) comprises a second current-limiting resistor (R2) and a first electronic switch (K1) that are connected in series, wherein:
a control terminal of the first electronic switch (K1) functions as the control terminal of the power switching circuit (10); and
the control terminal of the first electronic switch (K1) is connected to a control terminal of the second electronic switch (K2) through an inverting buffer.

5. The drive circuit of a power conversion device according to claim 3 or 4, wherein an output voltage of the first branch (201) is less than an output voltage of the second branch (202); and
the drive voltage control signal is a signal that controls the first electronic switch (K1) to turn on when the power conversion device is in the normal operating state, and controls the first electronic switch (K1) to turn off when the power conversion device is in the transient process.

6. The drive circuit of a power conversion device according to claim 5, wherein a voltage of the second power supply (V2) is greater than a voltage of the first power supply (V1), and a resistance value of the first current-limiting resistor (R1) is equal to a resistance value of the second current-limiting resistor (R2); or
the voltage of the second power supply (V2) is equal to the voltage of the first power supply (V1), and the resistance value of the first current-limiting resistor (R1) is greater than the resistance value of the second current-limiting resistor (R2); or
the voltage of the second power supply (V2) is greater than the voltage of the first power supply (V1), and the resistance value of the first current-limiting resistor (R1) is greater than the resistance value of the second current-limiting resistor (R2).

7. The drive circuit of a power conversion device according to claim 3, wherein the first electronic switch (K1) is any one of a metal oxide semiconductor field effect transistor, MOSFET, a triode, an insulated gate bipolar transistor, IGBT, or a combination of at least two of a MOSFET, a triode, and an IGBT.

8. The drive circuit of a power conversion device according to any one of claims 1 to 4, further comprising an amplifying circuit (40),
wherein the control terminal of each of the power semiconductor devices is connected, through the respective drive resistor, to an output terminal of a corresponding amplifying circuit (40); and
an input terminal of each amplifying circuit (40) is connected to an output terminal of a corresponding isolation module (30).

9. The drive circuit of a power conversion device according to any one of claims 1 to 4, wherein the isolation power supply (20) uses open-loop control.

10. The drive circuit of a power conversion device according to any one of claims 1 to 4, wherein the isolation module (30) is any one of an isolation optocoupler, an isolation capacitive coupler, or an isolation magnetic coupler.

11. A power conversion device, comprising: a controller (830), M power conversion modules (820), and the drive circuit (810) according to any one of claims 1 to 10, M being a positive integer,
wherein the controller (830) is connected to a control terminal of each power semiconductor device in the M power conversion modules (820) through the drive circuit (830).

12. An inverter, comprising: a controller (430), M power conversion modules (420), and the drive circuit (410) according to any one of claims 1 to 10, M being a positive integer,
wherein the M power conversion modules (420) comprises at least one inverter circuit; and
the controller (430) is connected to a control terminal of each power semiconductor device in the M power conversion modules (420) through the drive circuit (410).

## Patentansprüche

1. Treiberschaltung einer Leistungsumwandlungsvorrichtung, wobei die Treiberschaltung Folgendes umfasst: eine Mehrzahl von Isolationsmodulen (30) und mindestens eine Isolationsleistungsversorgung (20), und wobei eine Hauptschaltung der Leistungsumwandlungsvorrichtung eine Mehrzahl von Leistungshalbleitervorrichtungen umfasst, wobei:
ein Steueranschluss jeder der Leistungshalbleitervorrichtungen über einen jeweiligen Ansteuerwiderstand mit einem Ausgangsanschluss eines entsprechenden Isolationsmoduls (30) verbunden ist;
ein Leistungsversorgungsanschluss jedes der Isolationsmodule (30) mit einem Ausgangsanschluss der Isolationsleistungsversorgung (20) verbunden ist und dazu eingerichtet ist, eine entsprechende Ansteuerspannung zu empfangen;
ein Eingangsanschluss jedes der Isolationsmodule (30) mit einem ersten Ausgangsanschluss einer Steuereinheit in der Leistungsumwandlungsvorrichtung verbunden ist und dazu eingerichtet ist, ein Pulsweitenmodulationssignal (PWM-Signal) für eine entsprechende Leistungshalbleitervorrichtung zu empfangen; wobei die Treiberschaltung ferner mindestens einen Leistungsschaltkreis (10) umfasst und wobei
ein Eingangsanschluss der Isolationsleistungsversorgung (20) mit einem Ausgangsanschluss des Leistungsschaltkreises (10) verbunden ist;
ein Eingangsanschluss des Leistungsschaltkreises (10) mit einer Leistungsversorgung verbunden ist;
ein Steueranschluss des Leistungsschaltkreises (10) mit einem zweiten Ausgangsanschluss der Steuereinheit verbunden ist und dazu eingerichtet ist, ein Ansteuerspannungs-Steuersignal zu empfangen; und
der Leistungsschaltkreis (10) dazu eingerichtet ist: eine Ausgangsspannung des Leistungsschaltkreises (10) entsprechend dem Ansteuerspannungs-Steuersignal zu ändern, wodurch eine Ansteuerspannung jedes der Isolationsmodule (30) gleich einer voreingestellten Spannung ist, wenn sich die Leistungsumwandlungsvorrichtung in einem Übergangsprozess befindet, und gleich einer Normalspannung ist, wenn sich die Leistungsumwandlungsvorrichtung in einem Normalbetriebszustand befindet.

2. Treiberschaltung einer Leistungsumwandlungsvorrichtung nach Anspruch 1, wobei der Leistungsschaltkreis (10) Folgendes umfasst: einen Kondensator (C), einen ersten Zweig (201) und einen zweiten Zweig (202), wobei der erste Zweig (201) und der zweite Zweig (202) unterschiedliche Ausgangsspannungen aufweisen, wobei:
mindestens einer des ersten Zweigs (201) und des zweiten Zweigs (202) mit einem Steueranschluss versehen ist, der als Steueranschluss des Leistungsschaltkreises (10) fungiert;
ein Eingangsanschluss des ersten Zweigs (201) als Eingangsanschluss des Leistungsschaltkreises (10) fungiert und mit einer ersten Leistungsversorgung (V1) verbunden ist;
ein Eingangsanschluss des zweiten Zweigs (202) als ein weiterer Eingangsanschluss des Leistungsschaltkreises (10) fungiert und mit einer zweiten Leistungsversorgung (V2) verbunden ist;
ein Ausgangsanschluss des ersten Zweigs (201) und ein Ausgangsanschluss des zweiten Zweigs (202) beide mit einem Anschluss des Kondensators (C) verbunden sind und ein Verbindungspunkt davon als positive Elektrode des Ausgangsanschlusses des Leistungsschaltkreises (10) fungiert und
ein anderer Anschluss des Kondensators (C) geerdet ist und als negative Elektrode des Ausgangsanschlusses des Leistungsschaltkreises (10) fungiert.

3. Treiberschaltung einer Leistungsumwandlungsvorrichtung nach Anspruch 2, wobei der erste Zweig (201) einen ersten Strombegrenzungswiderstand (R1) und eine erste Diode (D1) umfasst und der zweite Zweig (202) Folgendes umfasst: einen zweiten Strombegrenzungswiderstand (R2), einen ersten elektronischen Schalter (K1) und eine zweite Diode (D2), die in Reihe geschaltet sind, wobei:
eine Kathode der ersten Diode (D1) als Ausgangsanschluss des ersten Zweigs (201) fungiert, eine Anode der ersten Diode (D1) mit einem Anschluss des ersten Strombegrenzungswiderstands (R1) verbunden ist und ein anderer Anschluss des ersten Strombegrenzungswiderstands (R1) als Eingangsanschluss des ersten Zweigs (201) fungiert;
eine Kathode der zweiten Diode (D2) als Ausgangsanschluss des zweiten Zweigs (202) fungiert und eine Anode der zweiten Diode (D2) über den zweiten Strombegrenzungswiderstand (R2) mit einem Ausgangsanschluss des ersten elektronischen Schalters (K1) verbunden ist und
ein Eingangsanschluss des ersten elektronischen Schalters (K1) als Eingangsanschluss des zweiten Zweigs (202) fungiert und ein Steueranschluss des ersten elektronischen Schalters (K1) als Steueranschluss des Leistungsschaltkreises (10) fungiert.

4. Treiberschaltung einer Leistungsumwandlungsvorrichtung nach Anspruch 2, wobei der erste Zweig (201) einen ersten Strombegrenzungswiderstand (R1) und einen zweiten elektronischen Schalter (K2) umfasst, die in Reihe geschaltet sind, und der zweite Zweig (202) einen zweiten Strombegrenzungswiderstand (R2) und einen ersten elektronischen Schalter (K1) umfasst, die in Reihe geschaltet sind, wobei:
ein Steueranschluss des ersten elektronischen Schalters (K1) als Steueranschluss des Leistungsschaltkreises (10) fungiert; und
der Steueranschluss des ersten elektronischen Schalters (K1) über einen invertierenden Puffer mit einem Steueranschluss des zweiten elektronischen Schalters (K2) verbunden ist.

5. Treiberschaltung einer Leistungsumwandlungsvorrichtung nach Anspruch 3 oder 4, wobei eine Ausgangsspannung des ersten Zweigs (201) kleiner ist als eine Ausgangsspannung des zweiten Zweigs (202) und
das Ansteuerspannungs-Steuersignal ein Signal ist, das den ersten elektronischen Schalter (K1) so steuert, dass er eingeschaltet wird, wenn sich die Leistungsumwandlungsvorrichtung im Normalbetriebszustand befindet, und den ersten elektronischen Schalter (K1) so steuert, dass er ausgeschaltet wird, wenn sich die Leistungsumwandlungsvorrichtung im Übergangsprozess befindet.

6. Treiberschaltung einer Leistungsumwandlungsvorrichtung nach Anspruch 5, wobei eine Spannung der zweiten Leistungsversorgung (V2) größer ist als eine Spannung der ersten Leistungsversorgung (V1) und ein Widerstandswert des ersten Strombegrenzungswiderstands (R1) gleich einem Widerstandswert des zweiten Strombegrenzungswiderstands (R2) ist oder
die Spannung der zweiten Leistungsversorgung (V2) gleich der Spannung der ersten Leistungsversorgung (V1) ist und der Widerstandswert des ersten Strombegrenzungswiderstands (R1) größer ist als der Widerstandswert des zweiten Strombegrenzungswiderstands (R2) oder
die Spannung der zweiten Leistungsversorgung (V2) größer ist als die Spannung der ersten Leistungsversorgung (V1) und der Widerstandswert des ersten Strombegrenzungswiderstands (R1) größer ist als der Widerstandswert des zweiten Strombegrenzungswiderstands (R2).

7. Treiberschaltung einer Leistungsumwandlungsvorrichtung nach Anspruch 3, wobei der erste elektronische Schalter (K1) einer von einem Metalloxid-Halbleiter-Feldeffekttransistor, MOSFET, einer Triode, einem Bipolartransistor mit isoliertem Gate, IGBT, oder einer Kombination aus mindestens zwei von einem MOSFET, einer Triode und einem IGBT ist.

8. Treiberschaltung einer Leistungsumwandlungsvorrichtung nach einem der Ansprüche 1 bis 4, ferner umfassend eine Verstärkerschaltung (40),
wobei der Steueranschluss jeder der Leistungshalbleitervorrichtungen über den jeweiligen Ansteuerwiderstand mit einem Ausgangsanschluss einer entsprechenden Verstärkerschaltung (40) verbunden ist und
ein Eingangsanschluss jeder Verstärkerschaltung (40) mit einem Ausgangsanschluss eines entsprechenden Isolationsmoduls (30) verbunden ist.

9. Treiberschaltung einer Leistungsumwandlungsvorrichtung nach einem der Ansprüche 1 bis 4, wobei die Isolationsleistungsversorgung (20) eine Open-Loop-Regelung verwendet.

10. Treiberschaltung einer Leistungsumwandlungsvorrichtung nach einem der Ansprüche 1 bis 4, wobei das Isolationsmodul (30) eines von einem Isolationsoptokoppler, einem Isolationskapazitätskoppler oder einem Isolationsmagnetkoppler ist.

11. Leistungsumwandlungsvorrichtung, umfassend: eine Steuereinheit (830), M Leistungsumwandlungsmodule (820) und die Treiberschaltung (810) gemäß einem der Ansprüche 1 bis 10, wobei M eine positive ganze Zahl ist,
wobei die Steuereinheit (830) über die Treiberschaltung (830) mit einem Steueranschluss jeder Leistungshalbleitervorrichtung in den M Leistungsumwandlungsmodulen (820) verbunden ist.

12. Wechselrichter, umfassend: eine Steuereinheit (430), M Leistungsumwandlungsmodule (420) und die Treiberschaltung (410) gemäß einem der Ansprüche 1 bis 10, wobei M eine positive ganze Zahl ist,
wobei die M Leistungsumwandlungsmodule (420) mindestens eine Wechselrichterschaltung umfassen und
die Steuereinheit (430) über die Treiberschaltung (410) mit einem Steueranschluss jeder Leistungshalbleitervorrichtung in den M Leistungsumwandlungsmodulen (420) verbunden ist.

## Revendications

1. Circuit de commande d'un dispositif de conversion de puissance, le circuit de commande comprenant: une pluralité de modules d'isolation (30), et au moins une alimentation électrique d'isolation (20), et un circuit principal du dispositif de conversion de puissance comprenant une pluralité de dispositifs semi-conducteurs de puissance, dans lequel:
une borne de commande de chacun des dispositifs semi-conducteur de puissance est connectée, par l'intermédiaire d'une résistance de commande respective, à une borne de sortie d'un module d'isolation correspondant (30);
une borne d'alimentation électrique de chacun des modules d'isolation (30) est connectée à une borne de sortie de l'alimentation électrique d'isolation (20), et est configurée pour recevoir une tension de commande correspondante;
une borne d'entrée de chacun des modules d'isolation (30) est connectée à une première borne de sortie d'un contrôleur dans le dispositif de conversion de puissance, et est configurée pour recevoir un signal de modulation de largeur d'impulsion, PWM, pour un dispositif semi-conducteur de puissance correspondant; dans lequel le circuit de commande comprend en outre au moins un circuit de commutation de puissance (10), et dans lequel
une borne d'entrée de l'alimentation électrique d'isolation (20) est connectée à une borne de sortie du circuit de commutation de puissance (10);
une borne d'entrée du circuit de commutation de puissance (10) est connectée à une alimentation électrique;
une borne de commande du circuit de commutation de puissance (10) est connectée à une deuxième borne de sortie du contrôleur, et est configurée pour recevoir un signal de commande de tension de commande; et
le circuit de commutation de puissance (10) est configuré pour: modifier une tension de sortie du circuit de commutation de puissance (10) en fonction du signal de commande de tension de commande, de sorte qu'une tension de commande de chacun des modules d'isolation (30) est égale à une tension prédéfinie lorsque le dispositif de conversion de puissance est dans un processus transitoire, et est égale à une tension normale lorsque le dispositif de conversion de puissance est dans un état de fonctionnement normal.

2. Le circuit de commande d'un dispositif de conversion de puissance selon la revendication 1, dans lequel le circuit de commutation de puissance (10) comprend: un condensateur (C), une première branche (201) et une deuxième branche (202), la première branche (201) et la deuxième branche (202) ayant des tensions de sortie différentes, dans lequel:
au moins l'une de la première branche (201) et de la deuxième branche (202) est pourvue d'une borne de commande fonctionnant comme la borne de commande du circuit de commutation de puissance (10);
une borne d'entrée de la première branche (201) fonctionne comme une borne d'entrée du circuit de commutation de puissance (10), et est connectée à une première alimentation électrique (V1);
une borne d'entrée de la deuxième branche (202) fonctionne comme une autre borne d'entrée du circuit de commutation de puissance (10), et est connectée à une deuxième alimentation électrique (V2);
une borne de sortie de la première branche (201) et une borne de sortie de la deuxième branche (202) sont toutes deux connectées à une borne du condensateur (C), et un point de connexion de celui-ci fonctionne comme une électrode positive de la borne de sortie du circuit de commutation de puissance (10); et
une autre borne du condensateur (C) est mise à la terre, et fonctionne comme une électrode négative de la borne de sortie du circuit de commutation de puissance (10).

3. Le circuit de commande d'un dispositif de conversion de puissance selon la revendication 2, dans lequel la première branche (201) comprend une première résistance de limitation de courant (R1) et une première diode (D1), et la deuxième branche (202) comprend: une deuxième résistance de limitation de courant (R2), un premier commutateur électronique (K1), et une deuxième diode (D2) qui sont connectés en série, dans lequel:
une cathode de la première diode (D1) fonctionne comme la borne de sortie de la première branche (201), une anode de la première diode (D1) est connectée à une borne de la première résistance de limitation de courant (R1), et une autre borne de la première résistance de limitation de courant (R1) fonctionne comme la borne d'entrée de la première branche (201);
une cathode de la deuxième diode (D2) fonctionne comme la borne de sortie de la deuxième branche (202), et une anode de la deuxième diode (D2) est connectée à une borne de sortie du premier commutateur électronique (K1) par l'intermédiaire de la deuxième résistance de limitation de courant (R2); et
une borne d'entrée du premier commutateur électronique (K1) fonctionne comme la borne d'entrée de la deuxième branche (202), et une borne de commande du premier commutateur électronique (K1) fonctionne comme la borne de commande du circuit de commutation de puissance (10).

4. Le circuit de commande d'un dispositif de conversion de puissance selon la revendication 2, dans lequel la première branche (201) comprend une première résistance de limitation de courant (R1) et un deuxième commutateur électronique (K2) qui sont connectés en série, et la deuxième branche (202) comprend une deuxième résistance de limitation de courant (R2) et un premier commutateur électronique (K1) qui sont connectés en série, dans lequel:
une borne de commande du premier commutateur électronique (K1) fonctionne comme la borne de commande du circuit de commutation de puissance (10); et
la borne de commande du premier commutateur électronique (K1) est connectée à une borne de commande du deuxième commutateur électronique (K2) par l'intermédiaire d'un tampon inverseur.

5. Le circuit de commande d'un dispositif de conversion de puissance selon la revendication 3 ou 4, dans lequel une tension de sortie de la première branche (201) est inférieure à une tension de sortie de la deuxième branche (202); et
le signal de commande de la tension de commande est un signal qui commande le premier commutateur électronique (K1) pour qu'il s'allume lorsque le dispositif de conversion de puissance est dans l'état de fonctionnement normal, et qui commande le premier commutateur électronique (K1) de s'éteigne lorsque le dispositif de conversion de puissance est dans le processus transitoire.

6. Le circuit de commande d'un dispositif de conversion de puissance selon la revendication 5, dans lequel une tension de la deuxième alimentation électrique (V2) est supérieure à une tension de la première alimentation électrique (V1), et une valeur de résistance de la première résistance de limitation de courant (R1) est égale à une valeur de résistance de la deuxième résistance de limitation de courant (R2); ou
la tension de la deuxième alimentation électrique (V2) est égale à la tension de la première alimentation électrique (V1), et la valeur de résistance de la première résistance de limitation de courant (R1) est supérieure à la valeur de résistance de la deuxième résistance de limitation de courant (R2); ou
la tension de la deuxième alimentation électrique (V2) est supérieure à la tension de la première alimentation électrique (V1), et la valeur de résistance de la première résistance de limitation de courant (R1) est supérieure à la valeur de résistance de la deuxième résistance de limitation de courant (R2).

7. Le circuit de commande d'un dispositif de conversion de puissance selon la revendication 3, dans lequel le premier commutateur électronique (K1) est l'un quelconque d'un transistor à effet de champ à semi-conducteur à oxyde métallique, MOSFET, d'une triode, d'un transistor bipolaire à grille isolée, IGBT, ou d'une combinaison d'au moins deux parmi un MOSFET, une triode, et un IGBT.

8. Le circuit de commande d'un dispositif de conversion de puissance selon l'une des revendications 1 à 4, comprenant en outre un circuit d'amplification (40),
dans lequel la borne de commande de chacun des dispositifs semi-conducteurs de puissance est connectée, par l'intermédiaire de la résistance de commande respective, à une borne de sortie d'un circuit d'amplification correspondant (40); et
une borne d'entrée de chaque circuit d'amplification (40) est connectée à une borne de sortie d'un module d'isolation correspondant (30).

9. Le circuit de commande d'un dispositif de conversion de puissance selon l'une des revendications 1 à 4, dans lequel l'alimentation électrique d'isolation (20) utilise une commande en boucle ouverte.

10. Le circuit de commande d'un dispositif de conversion de puissance selon l'une des revendications 1 à 4, dans lequel le module d'isolation (30) est l'un quelconque d'un optocoupleur d'isolation, d'un coupleur capacitif d'isolation, ou d'un coupleur magnétique d'isolation.

11. Dispositif de conversion de puissance comprenant: un contrôleur (830), M modules de conversion de puissance (820), et le circuit de commande (810) selon l'une des revendications 1 à 10, M étant un nombre entier positif,
dans lequel le contrôleur (830) est connecté à une borne de commande de chaque dispositif semi-conducteur de puissance dans les M modules de conversion de puissance (820) par l'intermédiaire du circuit de commande (830).

12. Onduleur comprenant: un contrôleur (430), M modules de conversion de puissance (420), et le circuit de commande (410) selon l'une des revendications 1 à 10, M étant un nombre entier positif,
dans lequel les M modules de conversion de puissance (420) comprennent au moins un circuit onduleur; et
le contrôleur (430) est connecté à une borne de commande de chaque dispositif semi-conducteur de puissance dans les M modules de conversion de puissance (420) par l'intermédiaire du circuit de commande (410).
